# EUROPÄISCHE PATENTSCHRIFT

(11) **EP 2 481 080 B1**
(45) Veröffentlichungstag und Bekanntmachung des Hinweises auf die Patenterteilung: **24.10.2018**
(21) Anmeldenummer: 10721930.5
(22) Anmeldetag: 15.02.2010
(51) Int. Cl.: H01L 31/18, H01L 21/00, H01L 21/67

(54) **VERFAHREN UND VORRICHTUNG ZUM RÜCKÄTZEN EINER HALBLEITERSCHICHT**
METHOD AND DEVICE FOR ETCHING BACK A SEMICONDUCTOR LAYER
PROCÉDÉ ET DISPOSITIF D'AMINCISSEMENT PAR GRAVURE CHIMIQUE D'UNE COUCHE SEMI-CONDUCTRICE

(30) Priorität: 22.09.2009 DE 102009042288
(43) Veröffentlichungstag der Anmeldung: 01.08.2012
(73) Patentinhaber: RENA Technologies GmbH, 78148 Gütenbach (DE)
(72) Erfinder: DELAHAYE, Franck, 79279 Vörstetten (DE); SAULE, Werner, 78476 Allensbach (DE); WEFRINGHAUS, Eckard, 88709 Meersburg (DE); QUEISSER, Steffen, 77731 Willstätt (DE)
(74) Vertreter: Heyerhoff Geiger & Partner Patentanwälte PartGmbB
(86) Internationale Anmeldenummer: PCT/DE2010/000168
(87) Internationale Veröffentlichungsnummer: WO 2011/035748

(56) Entgegenhaltungen:
- EP-A1- 2 335 275
- WO-A1-2005/093788
- WO-A1-2010/037739
- DE-A1- 10 313 127
- JP-A- 2003 017 464

## Beschreibung

Die Erfindung betrifft ein Verfahren zum wenigstens teilweisen Rückätzen einer Halbleiterschicht gemäß dem Oberbegriff des Anspruchs 1 sowie eine Vorrichtung zu Durchführung dieses Verfahrens gemäß dem Oberbegriff des Anspruchs 15.

Das Rückätzen einer Halbleiterschicht ist Gegenstand des Fertigungsverfahrens vieler Halbleiterbauelemente. Unter einer Halbleiterschicht ist vorliegend eine halbleitende Schicht zu verstehen. Insbesondere findet das Rückätzen einer Halbleiterschicht Verwendung in der Solarzellenfertigung zum Rückätzen eines Emitters, welcher eine dotierte Halbleiterschicht darstellt. Ein solches Emitterrückätzen wird teilweise vorgenommen, wenn die Dotierstoffkonzentration an der Oberfläche der Halbleiterschicht so groß ist, dass eine erhöhte Oberflächenrekombinationsgeschwindigkeit bzw. eine erhöhte Emittersättigungsstromdichte den Wirkungsgrad der fertigen Solarzelle negativ beeinflussen.

Zu hohe Dotierstoffkonzentration an der Oberfläche einer Halbleiterschicht können beispielsweise auftreten bei Verwendung von besonderen Dotierstoffquellen oder wenn sich die erhöhte Dotierstoffoberflächenkonzentration ergibt, weil die Diffusion vorrangig danach ausgerichtet wird, andere Eigenschaften des Solarzellensubstrats als die Dotierstoffkonzentration an der Oberfläche der Halbleiterschicht zu beeinflussen; beispielsweise wenn mit der Diffusion gleichzeitig ein Getter-Effekt bewirkt werden soll.

Aus dem Stand der Technik ist bekannt, unerwünscht hohe Dotierstoffkonzentrationen an der Oberfläche einer Halbleiterschicht zu beseitigen, indem die Halbleiterschicht zurückgeätzt wird. Dies kann beispielsweise mittels Rückätzen der Halbleiterschicht in einer Ätzlösung erfolgen, welche Flusssäure (HF) und Ozon (O₃) enthält (vgl. beispielsweise EP 1 843 389 B1). Verfahren und Vorrichtungen zum einseitigen Ätzen von Substraten sind ferner in DE 103 13 127 A1, WO 2005/093788 A1, JP 2003-1746 A und WO 2010/037739 A1 beschrieben.

Der vorliegenden Erfindung liegt die Aufgabe zugrunde, ein gut kontrollierbares Alternativverfahren zum wenigstens teilweisen Rückätzen einer Halbleiterschicht eines Substrats sowie eine Vorrichtung zu dessen Durchführung zur Verfügung zu stellen.

Diese Aufgabe wird einerseits gelöst durch ein Verfahren mit den Merkmalen des Anspruchs 1, andererseits durch eine Vorrichtung mit den Merkmalen des Anspruchs 15.

Vorteilhafte Weiterbildungen sind jeweils Gegenstand abhängiger Unteransprüche.

Das erfindungsgemäße Verfahren sieht vor, dass das Substrat zumindest teilweise außerhalb einer Ätzlösung angeordnet wird und dass außerhalb der Ätzlösung gelegene Bereiche der Halbleiterschicht mittels der Ätzlösung entstammender reaktiver Dämpfe wenigstens zum Teil abgetragen werden. Ferner wird zur Einstellung der Rückätzrate der reaktiven Dämpfe ein Inertgas und/oder wenigstens ein Reaktivgas den außerhalb der Ätzlösung gelegenen Bereichen der rückzuätzenden Halbleiterschicht zugeführt.

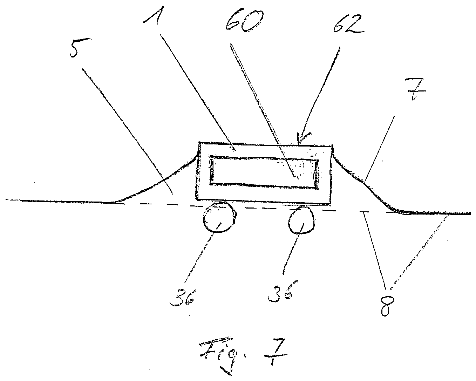

Eine Oberfläche der Ätzlösung stellt nicht notwendigerweise eine Ebene dar. Aufgrund von Benetzungsphänomenen kann die Oberfläche abschnittsweise gekrümmt sein, insbesondere an den Kanten des Substrats, wie dies für eine Oberfläche 7 einer Ätzlösung 5 in Figur 7 beispielhaft schematisch dargestellt ist. Hierin befindet sich das Substrat 60 zwar vollständig oberhalb eines Flüssigkeitsspiegels 8 der Ätzlösung 5. Dennoch sind Teile einer schematisch dargestellten dotierten Halbleiterschicht 1 in der Ätzlösung 5 angeordnet und stehen mit dieser in unmittelbarem Kontakt. Andere Bereiche der dotierten Halbleiterschicht 1, wie die an einer Oberseite 62 des Substrats 60 gelegenen Bereiche beispielsweise, befinden sich hingegen außerhalb der Ätzlösung 5. Der Flüssigkeitsspiegel 8 stellt eine Ebene dar und verläuft in dem Beispiel der Figur 7 in denjenigen Bereichen, in denen die Oberfläche 7 der Ätzlösung 5 gekrümmt ist, unterhalb der Oberfläche 7 der Ätzlösung 5, wie dies durch die gestrichelte Linie in Figur 7 angedeutet ist.

Unter einer Halbleiterschicht ist vorliegend jede halbleitende Schicht zu verstehen. Eine Phosphorsilikatglas- oder Borsilikatglasschicht, häufig schlicht als Phosphorglas- bzw. Borglas bezeichnet, ist demzufolge aufgrund ihrer elektrisch isolierenden Wirkung keine Halbleiterschicht im Sinne der vorliegenden Erfindung.

Handelt es sich bei der Halbleiterschicht beispielsweise um eine dotierte oder undotierte Siliziumschicht, so kann als Ätzlösung beispielsweise eine Lösung Verwendung finden, welche einerseits ein Oxidans, z.B. Salpetersäure oder Ozon, und andererseits Flusssäure enthält. Besonders bewährt hat sich im Fall der siliziumbasierten Halbleiterschicht eine Ätzlösung welche Flusssäure und Salpetersäure enthält. Optional kann dieser zusätzlich Schwefelsäure beigemengt werden.

Mittels des erfindungsgemäßen Verfahrens kann eine dotierte Halbleiterschicht rückgeätzt werden. In einer Ausführungsvariante der Erfindung wird eine dotierte Siliziumschicht rückgeätzt. Dabei wird bevorzugt als Substrat ein Siliziumsubstrat verwendet und die dotierte Siliziumschicht durch Einbringung von Dotierstoff in das Siliziumsubstrat ausgebildet. Die Einbringung des Dotierstoffs kann dabei grundsätzlich auf beliebige Art erfolgen, im Bereich der Solarzellenfertigung wird dieser üblicherweise in das Siliziumsubstrat eindiffundiert.

Eine Weiterbildung der Erfindung sieht vor, dass das Substrat derart angeordnet wird, dass Teile der Halbleiterschicht sich in der Ätzlösung befinden, und dass diese Teile der Halbleiterschicht mittels der Ätzlösung vollständig entfernt werden. Diese vollständige Entfernung ist nicht dahingehend zu verstehen, dass unterhalb der Oberfläche der Ätzlösung kein Halbleitermaterial verbleibt. Lediglich die in der jeweiligen Ausführungsvariante betrachtete Halbleiterschicht wird in der Ätzlösung vollständig entfernt. Wird beispielsweise eine Siliziumscheibe, und damit ein Siliziumsubstrat, als Substrat verwendet und in dieses von außen Dotierstoff eindiffundiert, sodass sich an der Oberfläche des Siliziumsubstrats eine dotierte Halbleiterschicht ausbildet, so werden lediglich diejenigen Teile der dotierten Halbleiterschicht, welche sich in der Ätzlösung befinden, mittels der Ätzlösung vollständig entfernt. Das Übrige unterhalb der Oberfläche der Ätzlösung gelegene Silizium wird hingegen nicht notwendigerweise abgetragen. Dieses verbleibende Silizium braucht jedoch nicht zwingenderweise undotiert zu sein, sondern kann Dotierstoff eines anderen Typs enthalten als in der entfernten dotierten Halbleiterschicht vorhanden war.

In einer bevorzugten Ausgestaltungsvariante der Erfindung werden während der vollständigen Entfernung der in der Ätzlösung befindlichen Teile der Halbleiterschicht außerhalb der Ätzlösung gelegene Bereiche der dotierten Halbleiterschicht wenigstens zum Teil mittels der reaktiven Dämpfe abgetragen.

Im Bereich der Solarzellenfertigung können mittels des erfindungsgemäßen Verfahrens sehr stark dotierte und damit sehr rekombinationsaktive Schichten, welche teilweise als "dead layer" bezeichnet werden, entfernt werden. In einer anderen Ausführungsvariante wird mittels des erfindungsgemäßen Verfahrens ein Emitter eines Solarzellensubstrats alternativ oder zusätzlich zur "dead layer" rückgeätzt. Auf welche Weise "dead layer" oder Emitter ausgebildet wurden, ist dabei grundsätzlich unerheblich. Beispielsweise kann dies durch Implantations- oder chemische oder physikalische Abscheideverfahren erfolgt sein oder durch Eindiffusion von Dotierstoff, was die am weitesten verbreitete Vorgehensweise darstellt. Dabei kann es sich sowohl um einen n-Typ oder auch um einen p-Typ Emitter handeln. Das erfindungsgemäße Verfahren ist demnach bei beiden Solarzellentypen anwendbar. Das erfindungsgemäße Verfahren ist zudem einfach in bestehende Anlagen integrierbar, da bei der Solarzellenfertigung in vielen Fertigungslinien ohnehin nasschemische Ätzvorgänge vorgesehen sind.

In einer bevorzugten Ausgestaltungsvariante der Erfindung wird der Emitter um 1 bis 25 Ω/sq zurückgeätzt. Bei üblicherweise bei der industriellen Solarzellenfertigung eingesetzten Emitterprofilen entspricht dies typischerweise einem Materialabtrag von 1 bis 50 nm. Auf diese Weise können Wirkungsgradverbesserungen bei den fertigen Solarzellen von bis zu 0,4 % absolut bei industriell gefertigten Siliziumsolarzellen erzielt werden. Als Einwirkdauer der reaktiven Dämpfe hat sich eine Zeitspanne von 30 Sekunden bis 5 Minuten bewährt.

Eine Weiterbildung der Erfindung sieht vor, dass das Solarzellensubstrat derart angeordnet wird, dass sich eine spätere Emitterseite des Solarzellensubstrats außerhalb der Ätzlösung befindet und sich eine der Emitterseite gegenüberliegende Seite des Solarzellensubstrats in der Ätzlösung befindet. Diese Ausführungsvariante ist vor allem bei denjenigen Solarzellensubstraten vorteilhaft, bei welchen entlang der gesamten Substratoberfläche ein Emitter ausgebildet wurde. Dies ist beispielsweise der Fall, wenn das Solarzellensubstrat einem Dotierstoffeintrag aus einer Gasphasendiffusion ausgesetzt wird, ohne dass ein Teil der Oberfläche gegenüber dem Dotierstoffeintrag geschützt wird. Eine solche oder ähnliche ganzflächige Emitterdiffusion wird bei der industriellen Solarzellenf ertigung häufig verwendet. Dies hat zur Folge, dass ein Kurzschluss der Kontakte der Solarzelle, üblicherweise als Front- und Rückkontakt bezeichnet, über eine durchgehende Emitterschicht verhindert werden muss. Zu diesem Zweck wird der durchgehende Emitter üblicherweise unterbrochen, was häufig als Kantenisolation bezeichnet wird. Hierbei wird eine durch die Emitterschicht gebildete, von der Emitterseite des Solarzellensubstrats zu der gegenüberliegenden Seite reichende elektrisch leitende Verbindung unterbrochen. Dies kann beispielsweise durch ein Einsägen von Gräben entlang den Kanten oder ein Abätzen des Emitters entlang der Kanten des Solarzellensubstrats erfolgen.

Der Begriff der Kantenisolation ist insoweit missverständlich, als dass eine Entfernung des Emitters nicht zwingend nur an den Kanten des Solarzellensubstrats erfolgen muss. Gemäß WO 2005/093788 A1 wird beispielsweise die Emitterseite eines Solarzellensubstrats außerhalb einer Ätzlösung angeordnet und die der Emitterseite gegenüberliegende Seite des Solarzellensubstrats in der Ätzlösung. Die sich in der Ätzlösung befindlichen Teile des Emitters werden sodann mittels der Ätzlösung vollständig entfernt. Hierdurch wird die elektrisch leitende Verbindung von der Emitterseite zu der der Emitterseite gegenüberliegende Seite des Solarzellensubstrats unterbrochen.

Bei der beschriebenen Weiterbildung des erfindungsgemäßen Verfahrens lässt sich die Kantenisolation mit dem Rückätzen des Emitters verbinden. Während die Kantenisolation erfolgt, indem diejenigen Teile des Emitters, welche sich in der Ätzlösung befinden, vollständig entfernt werden, werden außerhalb der Ätzlösung gelegene Bereiche des Emitters mittels der reaktiven Dämpfe zurückgeätzt. Es kann somit aufwandsgünstig gleichzeitig die Kantenisolation wie auch das Rückätzen des Emitters erfolgen. Bei Verfahren gemäß dem Stand der Technik hingegen wird der Emitter erst nach erfolgter Kantenisolation zurückgeätzt, was einen zusätzlichen Prozessschritt und damit einen erhöhten Fertigungsaufwand mit sich bringt.

In den Verfahren gemäß dem Stand der Technik ist während der Kantenisolation die Emitterseite des Solarzellensubstrats gegenüber der Einwirkung von reaktiven Dämpfen geschützt, beispielsweise durch ein während einer Diffusion gebildetes Phosphor- oder Borsilikatglas. Eine solche Silikatglasschicht verhindert, dass der Emitter durch die reaktiven Dämpfe beschädigt wird, was sich negativ auf den Wirkungsgrad auswirken würde. Aufgrund der Hydrophilie einer solchen Silikatglasschicht besteht allerdings die Gefahr, dass die Emitterseite in Randbereichen von der Ätzlösung benetzt und der Emitter beschädigt wird. Eine bekannte Maßnahe, um eine derartige Schädigung des Emitters zu verhindern, ist eine Erhöhung der Viskosität der Ätzlösung. Zu diesem Zweck kann der Ätzlösung beispielsweise Schwefelsäure beigemengt werden. Weiterhin wird der beschriebenen Benetzung von Randbereichen der Emitterseite durch Feineinstellung von Parametern der Ätzlösung, zum Beispiel dem Flüssigkeitsspiegelniveau der Ätzlösung, deren Temperatur oder der Zu- und Ablaufgeschwindigkeit der Ätzlösung in einem Ätzlösungsbehälter, entgegengewirkt. Um eine Beschädigung des Emitters zu verhindern, müssen allerdings die Einfluss nehmenden Parameter der Ätzlösung jeweils in sehr engen Parameterfenstern gehalten werden.

Eine Weiterbildung der Erfindung sieht daher vor, dass eine auf der rückzuätzenden Halbleiterschicht vorhandene Silikatglasschicht vor dem Rückätzen der Halbleiterschicht entfernt wird. Dies erfolgt vorzugsweise auf nasschemische Weise. Durch die Entfernung der Silikatglasschicht ist die Oberfläche der rückzuätzenden Halbleiterschicht hydrophob. Dies bewirkt, dass selbst bei einer niederviskosen Ätzlösung, bzw. starker Meniskusbildung am Rand des Substrats, eine Benetzung der Oberseite des Substrats einfach vermieden werden kann. Die dort vorhandene Halbleiterschicht kann daher kontrolliert mittels der reaktiven Dämpfe zurückgeätzt werden. Eine Beeinträchtigung des Ätzergebnisses aufgrund von Ätzlösung, welche auf die Oberseite des Substrats, bzw. auf dort gelegene Bereiche der Halbleiterschicht, gelangt, ist nicht gegeben. Die Hydrophobie der außerhalb der Ätzlösung befindlichen Teile der Halbleiterschicht wirkt einer Benetzung dieser Teile der Halbleiterschicht mit der Ätzlösung entgegen, sodass hinsichtlich der die Ätzlösung betreffenden Parameter wie Temperatur, Zusammensetzung und damit letztlich Viskosität der Ätzlösung oder auch Zu- und Ablaufgeschwindigkeit der Ätzlösung sowie Feineinstellung des Niveaus des Flüssigkeitsspiegels der Ätzlösung breitere Parameterfenster bestehen, was die Prozessführung vereinfacht. Insbesondere kann auf eine Beimengung von Schwefelsäure zur Ätzlösung zum Zwecke der Erhöhung der Viskosität derselben verzichtet werden. Diese Vorteile wirken sich besonders stark aus bei Solarzellen, welche aus monokristallinen, texturierten Substraten gefertigt werden.

Weiterhin hat sich gezeigt, dass bei vergleichsweise schwierig entfernbaren Phosphorgläsern sich die beschriebene Weiterbildung des erfindungsgemäßen Verfahrens vorteilhaft auswirken kann, da es eine bessere Reinigungswirkung mit sich bringt, sodass bei einer nachfolgenden Siliziumnitridabscheidung eine geringere Gefahr von Abplatzungen (sog. blistering) besteht.

Bei einer vorteilhaften Ausgestaltungsvariante des erfindungsgemäßen Verfahrens werden zur Einstellung der Rückätzrate für das Rückätzen der Halbleiterschicht die reaktiven Dämpfe teilweise abgesaugt. Auf diese Weise kann ein homogenes Rückätzen erfolgen.

Bei einer anderen Ausgestaltungsvariante der Erfindung wird zur Einstellung der Rückätzrate der reaktiven Dämpfe ein Inertgas den außerhalb der Ätzlösung gelegenen Bereichen der rückzuätzenden Halbleiterschicht zugeführt. Unter einem Inertgas ist dabei ein Gas oder Gasgemisch zu verstehen, welches weder mit der Ätzlösung, den reaktiven Dämpfen, dem Substrat oder der Halbleiterschicht in relevantem Umfang reagiert; beispielsweise können Edelgase oder Luft Verwendung finden. Das Zuführen eines Inertgases kann alternativ oder ergänzend zur teilweisen Absaugung der reaktiven Dämpfe erfolgen. Die Einstellwirkung des zugeführten Inertgases beruht darauf, dass durch dieses die reaktiven Dämpfe teilweise von der rückzuätzenden Halbleiterschicht verdrängt werden.

Bei einer weiteren Ausgestaltungsvariante wird den außerhalb der Ätzlösung gelegenen Bereichen der rückzuätzenden Halbleiterschicht wenigstens ein Reaktivgas zugeführt. Dabei kann es sich grundsätzlich um eine beliebige, für den jeweiligen Anwendungsfall geeignete reaktive Spezies handeln. Bei Siliziumbasierten Halbleiterschichten haben sich beispielsweise Oxidantien bewährt. Vorzugsweise wird als Reaktivgas gasförmiger Fluorwasserstoff oder gasförmiges Ozon zugeführt. Besonders bevorzugt werden gasförmiger Fluorwasserstoff und gasförmiges Ozon zugeführt. Ozon hat, insbesondere bei Siliziumhalbleiterschichten, eine Oxidationswirkung, sodass in Kombination mit einer nachfolgenden Entfernung des erzeugten Oxids, insbesondere eines Siliziumoxids, die Rückätzrate beeinflusst werden kann. Das wenigstens eine Reaktivgas kann alternativ oder ergänzend zur teilweisen Absaugung der reaktiven Dämpfe und/oder der Inertgaszufuhr zugeführt werden. Die beschriebenen Weiterbildungen der teilweisen Absaugung der reaktiven Dämpfe, der Inertgaszufuhr und der Zufuhr des wenigstens einen Reaktivgases können somit grundsätzlich in beliebiger Weise kombiniert oder einzeln eingesetzt werden.

Bei einer anderen Ausführungsvariante des erfindungsgemäßen Verfahrens werden zur Einstellung der Rückätzrate für das Rückätzen der Halbleiterschicht außerhalb der Ätzlösung gelegene Bereiche der rückzuätzenden Halbleiterschicht während des Rückätzens mit elektromagnetischer Strahlung bestrahlt. Dabei findet vorzugsweise ultraviolettes Licht (UV-Licht) oder Laserstrahlung Verwendung. Durch die Bestrahlung mit elektromagnetischer Strahlung kann die Bildung reaktiver Verbindungen in den bestrahlten Gebieten, und auf diese Weise die Rückätzrate, beeinflusst werden. Insbesondere kann die Bildung von Ozon gefördert werden. Ergänzend oder alternativ ist es möglich, mittels der elektromagnetischen Strahlung in Solarzellensubstraten eine Spannung zu induzieren, wodurch ein Redoxpotential generiert werden kann, über welches die Rückätzrate beeinflussbar ist. Für letzteres bedarf es offensichtlich der Bestrahlung mit elektromagnetischer Strahlung in einem Wellenlängenbereich, in welchem das Solarzellensubstrat sensitiv ist. Der Einsatz elektromagnetischer Strahlung zur Einstellung der Rückätzrate kann ergänzend oder alternativ zu den bislang beschriebenen Möglichkeiten der Einstellung der Rückätzrate vorgesehen werden.

Eine Weiterbildung der Erfindung sieht vor, dass in außerhalb der Ätzlösung gelegenen Bereichen der Halbleiterschicht die Halbleiterschicht in Teilbereichen lokal stärker oder schwächer rückgeätzt wird als in der Umgebung dieser Teilbereiche.

Solch eine lokal stärkere oder schwächere Rückätzung kann auf verschiedene Weisen realisiert werden. Beispielsweise kann eine lokal stärkere Rückätzung realisiert werden durch lokales Bestrahlen der Halbleiterschicht in den Teilbereichen, beispielsweise mittels eines Lasers oder mit Hilfe von Belichtungsmasken, welche Öffnungen für die lokal stark rückzuätzenden Teilbereiche aufweisen. Alternativ kann eine lokal stärkere oder schwächere Rückätzung verwirklicht werden durch ein lokal verstärktes oder abgeschwächtes Absaugen der reaktiven Dämpfe. Weiterhin ist es denkbar, Inertgase oder Reaktivgase, wie beispielsweise Ozon, in den Teilbereichen lokal verstärkt oder abgeschwächt zuzuführen. Eine andere Realisierungsmöglichkeit für lokal schwächere Rückätzungen besteht darin, die Teilbereiche lokal zu maskieren, beispielsweise mittels Rundschnüren, welche auf diese Teilbereiche aufgebracht werden. Weiterhin besteht die Möglichkeit, reaktive Verbindungen, beispielsweise Ozon, lokal in den Teilbereichen zumindest teilweise zu zerstören, indem in diesen Teilbereichen lokal Katalysatoren aufgebracht oder zugeführt werden, sodass dort eine schwächere Rückätzung erfolgt. Die vorgenannten Maßnahmen zur Realisierung einer lokal stärkeren oder schwächeren Rückätzung können jeweils für sich oder in beliebiger Kombination verwendet werden.

Durch die beschriebene lokal stärkere oder schwächere Rückätzung in Teilbereichen können aufwandsgünstig mehrstufige Dotierungen ausgebildet werden. Insbesondere können bei Solarzellensubstraten selektive Emitter aufwandsgünstig realisiert werden. Hierzu wird die dotierte Halbleiterschicht, bzw. der Emitter, in Regionen späterer Kontaktierung schwächer rückgeätzt oder in der Umgebung dieser Regionen stärker rückgeätzt.

Eine Weiterbildung der Erfindung sieht vor, dass das Substrat in einem zusätzlichen Ätzschritt zumindest teilweise, vorzugsweise vollständig, in einem Zusatzätzmedium angeordnet wird, mittels welchem die Halbleiterschicht teilweise rückgeätzt wird, bevor oder nachdem in einem Hauptätzschritt wenigstens ein Teil der Halbleiterschicht mittels der reaktiven Dämpfe abgetragen wird. Unter einer vollständigen Anordnung in dem Zusatzätzmedium ist dabei zu verstehen, dass die gesamte Oberfläche des Substrats dem Zusatzätzmedium ausgesetzt wird. Handelt es sich bei dem Zusatzätzmedium um eine Ätzlösung, so wird diese nachfolgend als Zusatzätzlösung bezeichnet. Eine vollständige Anordnung in der Zusatzätzlösung würde demnach bedeuten, dass das Substrat vollständig in die Zusatzätzlösung eingetaucht ist. Das Substrat befindet sich demnach vollständig unter der Oberfläche der Zusatzätzlösung. Als Zusatzätzlösung kann beispielsweise eine Ätzlösung verwendet werden, welche Flusssäure und Ozon aufweist. Alternativ kann anstelle einer Zusatzätzlösung ein Zusatzätzgasgemisch verwendet werden. Eine vollständige Anordnung in diesem Zusatzätzgasgemisch ist gegeben, wenn jede Stelle der Oberfläche des Substrats dem Zusatzätzgasgemisch ausgesetzt ist. Als Zusatzätzgasgemisch kann grundsätzlich jedes die Substratoberfläche ätzende Gas bzw. Gasgemisch Verwendung finden. In der Praxis hat sich beispielweise ein Zusatzätzgasgemisch bewährt, welches Flusssäuredämpfe und Ozongas aufweist.

Der beschriebene zusätzliche Ätzschritt gewährleistet eine gute Einstellbarkeit des Rückätzprozesses. Hierunter ist vorliegend zu verstehen, dass die Halbleiterschicht in einer gewünschten und einstellbaren Dicke zuverlässig und reproduzierbar rückgeätzt werden kann. In Kombination mit diesem zusätzlichen Ätzschritt ermöglicht der Hauptätzschritt eine hohe Rückätzrate. Im Hinblick auf die Verwendung des erfindungsgemäßen Verfahrens zum Zwecke des Emitterrückätzens von Solarzelensubstraten gewährleistet der zusätzliche Ätzschritt somit die gute Einstellbarkeit des Emitterrückätzens, während der Hauptätzschritt eine Emitterrückätzung in einer für die industrielle Fertigung relevanten Geschwindigkeit ermöglicht. Bei in der Solarzellenfertigung üblicherweise eingesetzten Standardemitterprofilen hat es sich bewährt, in dem Hauptätzschritt den Emitter derart stark zurückzuätzen, dass sich der Emitterschichtwiderstand um 3 bis 10 Ω/sq erhöht. Grundsätzlich ist dieser Wert jedoch unter anderem abhängig vom Ausgangsschichtwiderstand und dem verwendeten Emitterprofil.

Bevorzugt wird als Zusatzätzmedium eine Zusatzätzlösung verwendet, welche Flusssäure enthält. Ferner wird Ozon in die Zusatzätzlösung eingeleitet. Die Verwendung dieses Zusatzätzmediums hat sich in der Praxis bewährt.

Vorteilhafterweise wird mit der Zusatzätzlösung während des zusätzlichen Ätzschrittes eine auf der rückzuätzenden Halbleiterschicht angeordnete Silikatglasschicht entfernt. Hierbei kann es sich beispielsweise um eine Phosphorsilikatglasschicht oder Borsilikatglasschicht handeln. Ein derartiger modifizierter Silikatglasätzschritt, bei welchem neben dieser Silikatglasschicht die Halbleiterschicht teilweise rückgeätzt wird, kann mit geringem Aufwand in bestehende Prozesslinien integriert werden. Der beschriebene zusätzliche Ätzschritt kann in der Art einer kontinuierlichen Linienfertigung, also in einem sogenannten "Inline"-Prozess, erfolgen. Alternativ kann der zusätzliche Ätzschritt auch in der Art eines Stapelbetriebs durchgeführt werden, bei welchem mehrere Substrate in einem Halter gleichzeitig in dem Zusatzätzmedium angeordnet werden. Derartige Vorrichtungen werden häufig als "Batch"-Anlagen bezeichnet.

In einer vorteilhaften Ausgestaltungsvariante wird dem Zusatzätzmedium zur Einstellung der Rückätzrate wenigstens ein Element aus der Gruppe umfassend Salpetersäure, Schwefelsäure, Ammoniumhydroxid, Salzsäure und Wasserstoffperoxid beigemengt wird. Im Falle der Verwendung einer Zusatzätzlösung wird dieses wenigstens eine Element der Zusatzätzlösung beigemengt, im Falle der Verwendung eines Zusatzätzgasgemisches wird das wenigstens eine Element diesem Zusatzätzgasgemisch, bevorzugt in Dampfform, beigemengt.

Eine alternative oder ergänzende Möglichkeit zur Einstellung der Rückätzrate des Zusatzätzmediums stellt die Bestrahlung mit elektromagnetischer Strahlung, insbesondere mit UV-Licht, dar. Auf diese Weise kann, wie oben dargelegt, die Bildung reaktiver Spezies gefördert werden, teilweise ist auch die Erzeugung eines Redoxpotentials möglich, welches seinerseits Einfluss auf die Rückätzrate nimmt.

Als Rückätzrate des Zusatzätzmediums hat sich in der Praxis ein Wert von 1 bis 5 Ω/sq pro Minute bewährt. Diese ist jedoch unter anderem abhängig vom Ausgangsschichtwiderstand und dem verwendeten Emitterprofil.

Die erfindungsgemäße Vorrichtung zur Durchführung des Verfahrens weist einen Behälter für eine Ätzlösung auf, wobei ein Substrat relativ zu der Ätzlösung derart anordenbar ist, dass dieses zumindest teilweise außerhalb der in dem Behälter angeordneten Ätzlösung liegt. Die Vorrichtung weist weiterhin eine Absaugeinrichtung zur Absaugung von der Ätzlösung entstammenden, reaktiven Dämpfen auf, wobei mittels der Absaugeinrichtung die reaktiven Dämpfe derart absaugbar sind, dass außerhalb der Ätzlösung gelegene Bereiche einer Halbleiterschicht des Substrats mittels der reaktiven Dämpfe homogen rückätzbar sind.

In einer vorteilhaften Ausgestaltungsvariante der Vorrichtung ist eine Transportvorrichtung vorgesehen, mittels welcher Substrate relativ zu dem Behälter transportierbar sind. Hierbei kann es sich beispielsweise um Transportrollen, Transportwalzen oder -bänder oder um Hubbalkensysteme handeln. Die erfindungsgemäße Vorrichtung ist bevorzugt als kontinuierlich arbeitende Anlage (sog. Inline-Anlage) ausgestaltet, welche vorteilhaft in eine Linienfertigung integrierbar ist. Bevorzugt ist eine Steuereinrichtung, besonders bevorzugt eine Regeleinrichtung, für die Absaugeinrichtung vorgesehen.

Die erfindungsgemäße Vorrichtung sieht wenigstens eine Gaszuführung vor, mittels welcher außerhalb der Ätzlösung gelegenen Bereichen der Halbleiterschicht Gase zuführbar sind. Auf diese Weise können beispielsweise Inertgase zum Zwecke der teilweisen Verdrängung der reaktiven Dämpfe zugeführt werden, wodurch die Rückätzrate einstellbar ist. Alternativ oder ergänzend kann ein reaktives Gas, beispielsweise Ozon, zugeführt werden. Bei dem genannten Beispielgas kann im Falle einer Siliziumhalbleiterschicht deren Oxidation und damit deren Rückätzung verstärkt werden. Dies bietet eine weitere Möglichkeit zur Einstellung der Rückätzrate.

Bei einer Weiterbildung der Vorrichtung ist wenigstens eine Bestrahlungsvorrichtung vorgesehen, mittels welcher die Substrate mit elektromagnetischer Strahlung bestrahlbar sind. Soll mit der Bestrahlung lediglich das Rückätzen der außerhalb der Ätzlösung gelegenen Bereiche der Halbleiterschicht beeinflusst werden, so genügt eine Bestrahlbarkeit dieser Bereiche. Als Bestrahlungsvorrichtung hat sich eine UV-Lichtquelle bewährt.

Gemäß einer Weiterbildung ist die Bestrahlungsvorrichtung derart eingerichtet, dass die Substrate, insbesondere rückzuätzende Bereiche einer Halbleiterschicht, lokal bestrahlbar sind. Dies ist derart zu verstehen, dass gezielt einzelne Regionen der Substrate, bzw. der rückzuätzenden Halbleiterschicht, lokal bestrahlt werden können. Zu diesem Zweck kann beispielsweise ein Laser vorgesehen sein, vorzugsweise mit geeigneter Steuerungs- und Regelungseinrichtung. Mit dessen Hilfe kann ein lokal stärkeres Ätzen verwirklicht werden, was beispielsweise eine aufwandsgünstige Fertigung von selektiven Emittern ermöglicht, da in stärker rückgeätzten Bereichen eine geringere Dotierstoffkonzentration vorliegt als in weniger stark rückgeätzten Bereichen.

Eine Ausgestaltungsvariante der Vorrichtung sieht vor, dass zwischen der wenigstens einen Bestrahlungsvorrichtung und der Ätzlösung eine Bestrahlungsmaske angeordnet ist, mittels welcher die Substrate, vorzugsweise die außerhalb der Ätzlösung gelegenen Bereiche der Halbleiterschicht der Substrate, lokal bestrahlbar sind. Auf diese Weise kann ein lokal stärkeres oder schwächeres Ätzen realisiert werden, was im Bereich der Solarzellenfertigung beispielsweise eine aufwandsgünstige Fertigung eines selektiven Emitters ermöglicht. Die Bestrahlungsmaske kann dabei eine Alternative darstellen zu dem oben erwähnten Laser oder einer anderen Bestrahlungsvorrichtung, welche dazu eingerichtet ist das Substrat lokal zu bestrahlen. Grundsätzlich kann sie jedoch auch ergänzend zu einer derart eingerichteten Bestrahlungsvorrichtung, beispielsweise einem Laser, vorgesehen sein.

Die erfindungsgemäße Vorrichtung sieht eine Vorätzeinrichtung vor, mittels welcher die Halbleiterschicht und/oder eine auf der Halbleiterschicht angeordnete Silikatglasschicht vor der Rückätzung der Halbleiterschicht mittels der reaktiven Dämpfe zumindest teilweise abtragbar ist.

In einer bevorzugten Ausgestaltungsvariante weist die Vorätzeinrichtung einen Behälter für eine Zusatzätzlösung auf. Besonders bevorzugt ist zudem eine Gaszufuhr zur Einleitung von Gas in den Behälter für die Zusatzätzlösung vorgesehen. Als Zusatzätzlösung kann beispielsweise eine flusssäurehaltige Lösung Verwendung finden, wobei beispielsweise Ozon über die Gaszufuhr in diese Lösung eingeleitet werden kann.

In einer alternativen Ausgestaltungsvariante ist die Vorätzeinrichtung durch eine Ätzkammer realisiert, in welche reaktive Gase einleitbar sind, mittels welchen die Halbleiterschicht und/oder die Silikatglasschicht abtragbar sind. Beispielsweise können Ozon und gasförmiger Flurwasserstoff als reaktive Gase verwendet werden.

Sowohl die Variante der Zusatzätzlösung wie auch der Ätzkammer können auf einen Stapelbetrieb ausgerichtet sein. Die Variante der Zusatzätzlösung hat den Vorteil, dass sie vergleichsweise einfach als Linienbetrieb ausgestaltet werden kann, also "inline"-fähig ist. In der industriellen Fertigung ist daher in der Regel die Zusatzätzlösung vorteilhaft. Vorzugsweise ist die gesamte erfindungsgemäße Vorrichtung für den Linienbetrieb, also "inline"-fähig, ausgelegt, sodass eine Fließbandfertigung realisiert werden kann.

Sowohl das erfindungsgemäße Verfahren wie auch die erfindungsgemäße Vorrichtung ermöglichen einen schnellen, aufwandsgünstigen Abtrag von Halbleiterschichten, welcher dennoch gut kontrollierbar ist. Dies ist insbesondere bei der industriellen Solarzellenfertigung von Vorteil. Besonders vorteilhaft stellt sich in diesem Bereich die Kombination der Kantenisolation mit der Emitterrückätzung dar, da diese Prozessschritte zum einen aufwandsgünstig im Wesentlichen gleichzeitig durchgeführt werden können, sodass gesonderte Ätzschritte entfallen können, zum anderen der Emitter aufwandsgünstig und gut kontrollierbar zurückgeätzt werden kann, was signifikante Verbesserungen im Wirkungsgrad möglich macht.

Des Weiteren ermöglicht das erfindungsgemäße Verfahren wie auch die erfindungsgemäße Vorrichtung eine aufwandsgünstige Bestimmung ortsaufgelöster Emitterprofile. Dies beruht darauf, dass der Emitter gut kontrolliert rückgeätzt werden kann, sodass mit guter Tiefenauflösung ein Emitter iterativ rückgeätzt und nach jedem Rückätzschritt ortsaufgelöst der Schichtwiderstand bestimmt werden kann. Gegenüber bislang bekannten Verfahren hat dies insbesondere den Vorteil, dass diese Verfahrensweise auch auf texturierten Solarzellensubstraten anwendbar ist, bei welchen bislang eine ortsaufgelöste Emitterprofilbestimmung nicht zuverlässig durchgeführt werden konnte.

Im Folgenden wird die Erfindung anhand von Figuren näher erläutert. Soweit zweckdienlich, sind hierin gleichwirkende Elemente mit gleichen Bezugszeichen versehen. Es zeigen:
- Figur 1: Schematische Darstellung eines ersten Ausführungsbeispiels eines Verfahrens zum wenigstens teilweisen Rückätzen einer Halbleiterschicht sowie eines Ausführungsbeispiels einer Vorrichtung zur Durchführung dieses Verfahrens.
- Figur 2: Ein zweites Ausführungsbeispiel eines Verfahrens zum wenigstens teilweisen Rückätzen einer Halbleiterschicht sowie ein Ausführungsbeispiel einer Vorrichtung zur Durchführung dieses Verfahrens, jeweils in schematischer Darstellung.
- Figur 3: Prinzipdarstellung eines dritten Ausführungsbeispiels eines Verfahrens zum wenigstens teilweisen Rückätzen einer Halbleiterschicht sowie schematische Darstellung eines Ausführungsbeispiels einer Vorrichtung zur dessen Durchführung.
- Figur 4: Viertes Ausführungsbeispiel eines Verfahrens zum wenigstens teilweisen Rückätzen einer Halbleiterschicht sowie einer erfindungsgemäßen Vorrichtung zu dessen Durchführung, jeweils in schematischer Darstellung.
- Figur 5: Vergrößerte, schematische Schnittdarstellung durch ein Solarzellensubstrat mit lokal stärker rückgeätzter dotierter Halbleiterschicht, welches mittels den in den Figuren 3 und 4 dargestellten Verfahren und Vorrichtungen erhältlich ist.
- Figur 6: Eine weitere Ausführungsvariante eines Verfahrens zum wenigstens teilweisen Rückätzen einer Halbleiterschicht in schematischer Darstellung sowie Prinzipdarstellung einer Vorrichtung zu dessen Durchführung.
- Figur 7: Beispielhafte Illustration von Benetzungsphänomenen.

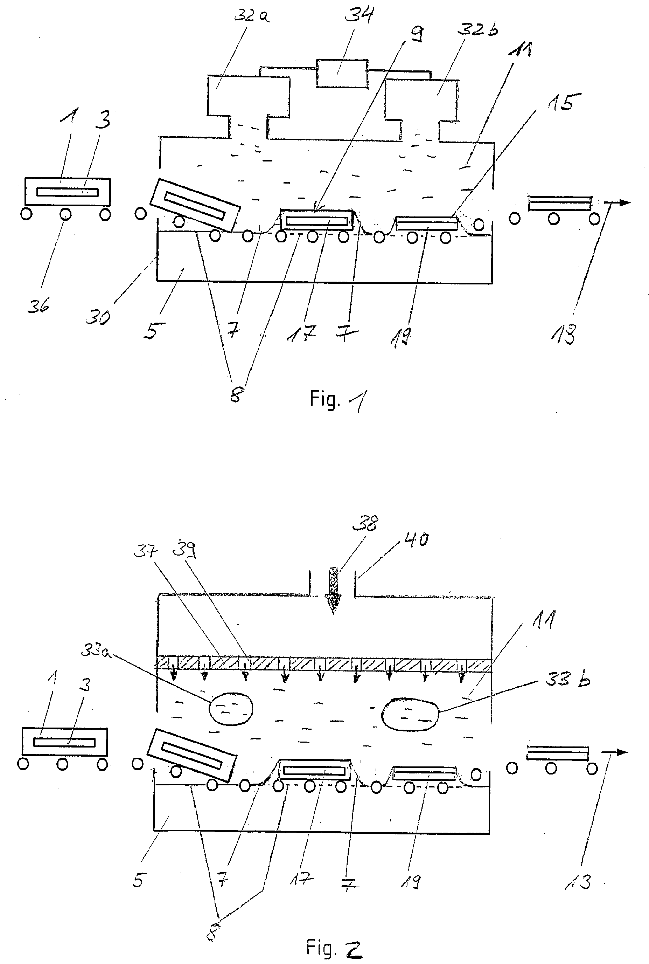

Figur 1 zeigt in schematischer Darstellung ein erstes Ausführungsbeispiel einer Vorrichtung zum wenigstens teilweisen Rückätzen einer Halbleiterschicht. Dieses sieht einen Behälter 30 für eine Atzlösung 5 vor. Relativ zu der Ätzlösung 5 sind Substrate 3, welche vorliegend als Solarzellensubstrate 3 ausgeführt sind, derart anordenbar, dass diese teilweise außerhalb der in dem Behälter 30 angeordneten Ätzlösung 5 liegen. Dies ist vorliegend realisiert mit Hilfe von Transportrollen 36, mittels welchen die Substrate in der durch den Pfeil 13 angedeuteten Transportrichtung relativ zu dem Behälter 30 transportiert werden können. Der Füllstand des Behälters 30 und die Anordnung der Transportrollen 36 sind in dem Ausführungsbeispiel der Figur 1 beispielhaft derart aufeinander abgestimmt, dass das Substrat 3 über dem - teilweise gestrichelt dargestellten - Flüssigkeitsspiegel 8 der Ätzlösung 5 liegt. Die Oberfläche 7 der Ätzlösung ist aufgrund von schematisch angedeuteten Benetzungsphänomenen an den Kanten der Substrate 3, 17, 19 teilweise gekrümmt. Anstelle von Transportrollen 36 kann offensichtlich ein anderes Transportsystem Verwendung finden, beispielsweise an sich bekannte Hubbalken- oder Transportbändersysteme.

Weiterhin sind zwei Absaugeinrichtung 32a, 32b vorgesehen, mit deren Hilfe reaktive Dämpfe 11, welche der Ätzlösung 5 entstammen, abgesaugt werden können. Die Absaugeinrichtungen 32a, 32b sind in einer Weise ausgelegt, dass die reaktiven Dämpfe 11 derart abgesaugt werden können, dass außerhalb der Ätzlösung 5 gelegene Bereiche einer dotierten Halbleiterschicht 1, welche das Substrat 3 aufweist, mittels der reaktiven Dämpfe 11 homogen rückätzbar sind. Die Maßgabe, die dotierte Halbleiterschicht 1 mittels der reaktiven Dämpfe 11 homogen rückzuätzen, beeinflusst die Ausgestaltung und Anzahl der Absaugeinrichtungen. Im dargestellten Ausführungsbeispiel sind beispielhaft zwei Absaugeinrichtungen 32a, 32b vorgesehen. Je nach Anforderung und baulicher Ausgestaltung der Vorrichtung können weitere oder weniger solcher Absaugeinrichtungen erforderlich sein.

Im dargestellten Ausführungsbeispiel der Figur 1 ist zudem eine Regeleinrichtung 34 für die Absaugeinrichtungen 32a, 32b vorgesehen, um einen zuverlässigen Betrieb zu gewährleisten. Im Einzelfall kann stattdessen eine Steuereinrichtung oder auch eine manuelle Einstellung jeder Absaugeinrichtung vorgesehen sein. Als Ätzlösung 5 hat sich bei rückzuätzenden Silizium-Halbleiterschichten eine wässrige Lösung bewährt, welche Flusssäure und Salpetersäure aufweist. Bei dem genannten Material können alternativ unter anderem Ätzlösungen Verwendung finden, welche einerseits einen oxidierenden Bestandteil, beispielsweise Ozon, und einen das entstandene Siliziumoxid ätzenden Bestandteil, häufig HF, enthalten.

Figur 1 illustriert weiterhin ein erstes Ausführungsbeispiel eines Verfahrens zum wenigstens teilweisen Rückätzen einer Halbleiterschicht. Das mit der dotierten Halbleiterschicht 1 versehene Substrat wird mittels den Transportrollen 36 dem Behälter zugeführt und durch eine geeignete Anordnung der Transportrollen 36 und entsprechenden Füllstand der Ätzlösung 5 zumindest teilweise außerhalb der Ätzlösung 5 angeordnet. Die Anordnung des Solarzellensubstrats 3 erfolgt dabei derart, dass eine spätere Emitterseite 9 des Solarzellensubstrats oberhalb der Oberfläche 7 der Ätzlösung zu liegen kommt, während die der Emitterseite 9 gegenüberliegende Seite des Solarzellensubstrats sich unterhalb der Oberfläche 7 und damit in der Ätzlösung befindet.

Die verschiedenen in Figur 1 dargestellten Solarzellensubstrate illustrieren von links nach rechts gleichsam eine zeitliche Abfolge des Verfahrens. Während zunächst das Solarzellensubstrat 3 noch mit einer vollständigen dotierten Halbleiterschicht 1 versehen ist, wird diese nach Einbringung des Solarzellensubstrats 3 in die Ätzlösung 5 teilweise abgetragen. So ergibt sich nach einer gewissen Verweildauer des Solarzellensubstrats 3 in der Ätzlösung 5 ein Solarzellensubstrat 17 mit teilweise abgetragener dotierter Halbleiterschicht 1. Auf der Emitterseite 9 ist der Abtrag mittels der reaktiven Dämpfe 11 erfolgt, welche der Ätzlösung 5 entstammen. Diejenigen Teile der Halbleiterschicht 1, welche sich in der Ätzlösung 5 befinden, wurden teilweise mittels der Ätzlösung 5 zurückgeätzt. Die Rückätzung mittels der Ätzlösung fällt dabei stärker aus als der Abtrag mittels der reaktiven Dämpfe. Infolgedessen ist bei dem Solarzellensubstrat 17 mit teilweise abgetragener dotierter Halbleiterschicht die verbliebene Halbleiterschicht 1 auf der Emitterseite 9 dicker als auf der gegenüberliegenden Seite.

Im weiteren Verfahrensablauf wird die dotierte Halbleiterschicht 1 auf der Emitterseite 9 wie auch auf der gegenüberliegenden Seite weiter abgetragen. Im Ergebnis ergibt sich ein Solarzellensubstrat 19 mit isolierten Kanten. Bei diesem wurde die dotierte Halbleiterschicht 1 auf der Emitterseite 9 nur bis zu einer verbleibenden Restdicke der Halbleiterschicht 1 abgetragen, sodass ein rückgeätzter Emitter 15 auf der Emitterseite 9 des Solarsellensubstrats 3 verbleibt. In der Ätzlösung 5 wurde die dotierte Halbleiterschicht 1 hingegen vollständig mittels der Ätzlösung 5 entfernt. Die ursprünglich durch die dotierte Halbleiterschicht 1 gegebene elektrisch leitende Verbindung von der Emitterseite 9 zu der gegenüberliegenden Seite des Solarzellensubstrats 3 wurde somit unterbrochen. Mittels des dargestellten Verfahrens kann demzufolge aufwandsgünstig ein Emitter rückgeätzt und gleichzeitig eine Kantenisolation vorgenommen werden.

Die Einstellung der Rückätzrate der Ätzlösung 5 erfolgt im Wesentlichen durch die Zusammensetzung der Ätzlösung 5. Die Rückätzrate der reaktiven Dämpfe 11 wird im Ausführungsbeispiel der Figur 1 eingestellt durch das Absaugen der reaktiven Dämpfe 11 mittels der Absaugungseinrichtungen 32a, 32b, wobei die Rückätzrate um so niedriger ausfällt, je stärker die reaktiven Dämpfe 11 abgesaugt werden.

Figur 2 zeigt ein zweites Ausführungsbeispiel einer Vorrichtung zum wenigstens Teilweisen Rückätzen einer HalbleiterSchicht. Dieses unterscheidet sich von dem Ausführungsbeispiel der Figur 1 dadurch, dass eine Gaszuführung 40 vorgesehen ist, mittels welcher Inertgas, beispielsweise ein Edelgas oder Luft, den außerhalb der Ätzlösung 5 gelegenen Bereichen der rückzuätzenden Halbleiterschicht 1 zugeführt werden kann. Die Gaszuführung erfolgt dabei im vorliegenden Ausführungsbeispiel über eins Gasverteilerplatte 37, welche in Figur 2 schematisch in einer Schnittdarstellung wiedergegeben ist. Diese Gasverteilerplatte weist eine Vielzahl von Öffnungen 39 auf, über welche das Inertgas den außerhalb der Ätzlösung 5 gelegenen Bereichen der rückzuätzenden dotierten Halbleiterschicht 1 zugeführt wird. Mittels des zugeführten Inertgases können in Verbindung mit Absaugöffnungen 33a, 33b einer nicht dargestellten Absaugeinrichtung die reaktiven Dämpfe 11 zum Teil von den außerhalb der Ätzlösung 5 gelegenen Bereichen der rückzuätzenden dotierten Halbleiterschicht 1 verdrängt werden. Auf diese Weise ermöglicht die Inertgaszufuhr eine Einstellung der Rückätzrate der reaktiven Dämpfe 11.

Über die Gaszuführung 40 können nicht nur Inertgase zugeführt werden. Es ist denkbar, diesen auch reaktive Gase, beispielsweise Ozon, beizumengen oder anstelle des Inertgases ausschließlich reaktive Gase zuzuführen. Mittels solcher reaktiver Gase kann das Rückätzen der dotierten Halbleiterschicht mittels der reaktiven Dämpfe beeinflusst werden. Beispielsweise können reaktive Spezies zugeführt werden, welche den Abtrag der dotierten Halbleiterschicht beschleunigen oder behindern. Im Falle von rückzuätzendem Siliziumhalbleiterschichten kann beispielsweise ein Oxidans zugeführt werden, welches die Oxidation der dotierten Halbleiterschicht und als Konsequenz hiervon deren Rückätzung verstärkt.

Figur 2 zeigt dementsprechend ein Ausführungsbeispiel eines erfindungsgemäßen Verfahrens, welches sich von dem aus Figur 1 bekannten dadurch unterscheidet, dass die Rückätzrate der reaktiven Dämpfe 11 alternativ oder zusätzlich zu einer Einstellung über die Absaugung der reaktiven Dämpfe 11 durch die Zufuhr von Inertgas, bzw. einer reaktiven Spezies wie gasförmigem Ozon, eingestellt wird.

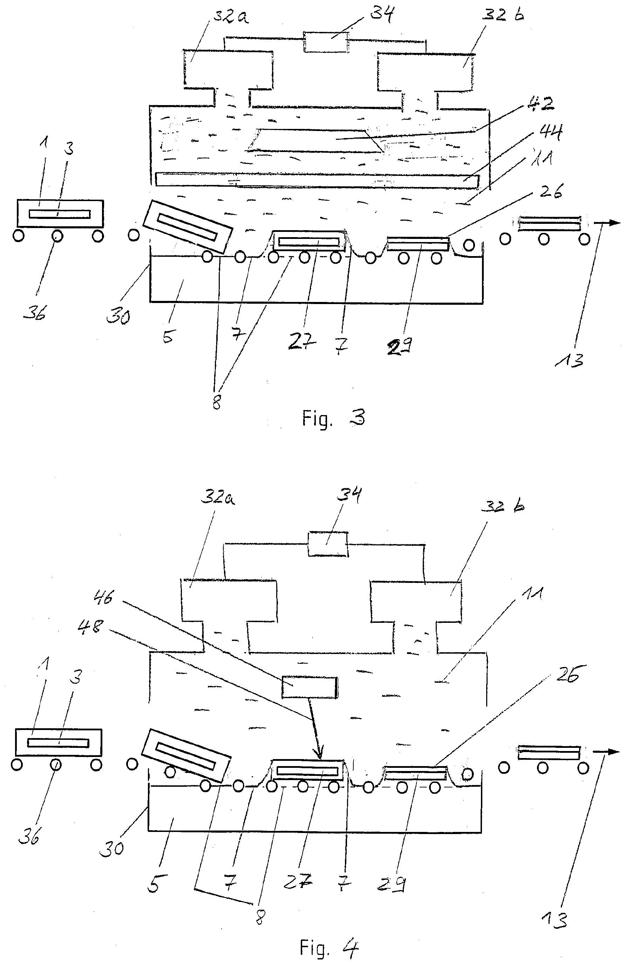

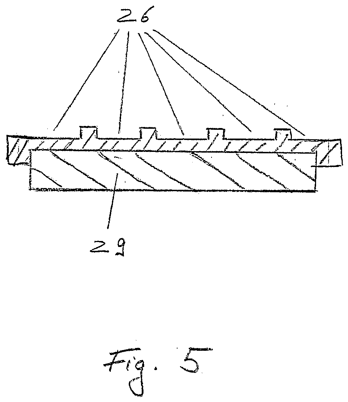

Die in Figur 3 dargestellte Ausgestaltungsvariante einer Vorrichtung zum wenigstens teilweisen Rückätzen einer Halbleiterschicht entspricht großteils derjenigen aus Figur 1. Ergänzend ist jedoch eine UV-Lampe 42 als Bestrahlungsvorrichtung vorgesehen, mittels welcher die Substrate, genauer die außerhalb der Ätzlösung 5 gelegenen Teile der dotierten Halbleiterschicht 1, bestrahlbar sind. Zwischen der UV-Lampe 42 und der Ätzlösung 5, und damit über der dotierten Halbleiterschicht 1, ist eine Bestrahlungsmaske 44 angeordnet. Diese Bestrahlungsmaske 44 weist Öffnungen auf, durch welche hindurch die Substrate 3 lokal mittels der UV-Lampe 42 bestrahlbar sind. Figur 3 zeigt daher ein lokal bestrahltes Solarzellensubstrat 27. Infolge der lokalen Bestrahlung mit UV-Licht wird lokal in den bestrahlten Bereichen die dotierte Halbleiterschicht 1 mittels der reaktiven Dämpfe 11 stärker rückgeätzt. In den durch die Bestrahlungsmaske 44 geschützten Bereichen hingegen wird schwächer rückgeätzt, sodass hier eine stärkere Dotierung verbleibt. Auf diese Weise kann aufwandsgünstig ein selektiver Emitter realisiert werden. Figur 5 zeigt in Blickrichtung der Transportrichtung 13 eine vergrößerte, schematische Schnittdarstellung des resultierenden Solarzellensubstrats 29 mit isolierten Kanten und lokal stärker rückgeätztem Emitter 26.

Figur 3 illustriert somit auch ein Verfahren, bei welchem die dotierte Halbleiterschicht infolge lokalen Bestrahlens mit elektromagnetischer Strahlung lokal stärker zurückgeätzt wird. Abgesehen von dieser lokal verstärkten Rückätzung stimmt das dargestellte Verfahren mit dem im Zusammenhang mit Figur 1 beschriebenen Verfahren überein.

Figur 4 zeigt eine alternative Ausgestaltungsvariante eines Verfahrens mit lokal stärkerer Rückätzung infolge eines lokalen Bestrahlens mit elektromagnetischer Strahlung. Im Unterschied zu der Ausgestaltungsvariante der Figur 3 erfolgt die lokale Bestrahlung hier mittels eines Lasers. Die Vorrichtung der Figur 4 weist im Unterschied zur derjenigen der Figur 3 daher anstelle der UV-Lampe 42 und der Bestrahlungsmaske 44 einen Laser 46 sowie eine zugehörige Lasersteuereinrichtung 46 auf. Hiermit kann die dotierte Halbleiterschicht sehr variabel mit einem Laserstrahl 48 lokal beleuchtet werden. Bei dem zugehörigen Verfahren wird das Solarzellensubstrat 27 dementsprechend mit dem Laserstrahl 48 lokal bestrahlt, lokal bestrahlte Bereiche werden erneut mittels der reaktiven Dämpfe 11 stärker rückgeätzt. Im Ergebnis ergibt sich wiederum ein Solarzellensubstrat 29 mit isolierten Kanten und lokal stärker rückgeätztem Emitter. Den lokal stärker rückgeätzten Emitter 26 illustriert erneut beispielhaft die Darstellung in Figur 5.

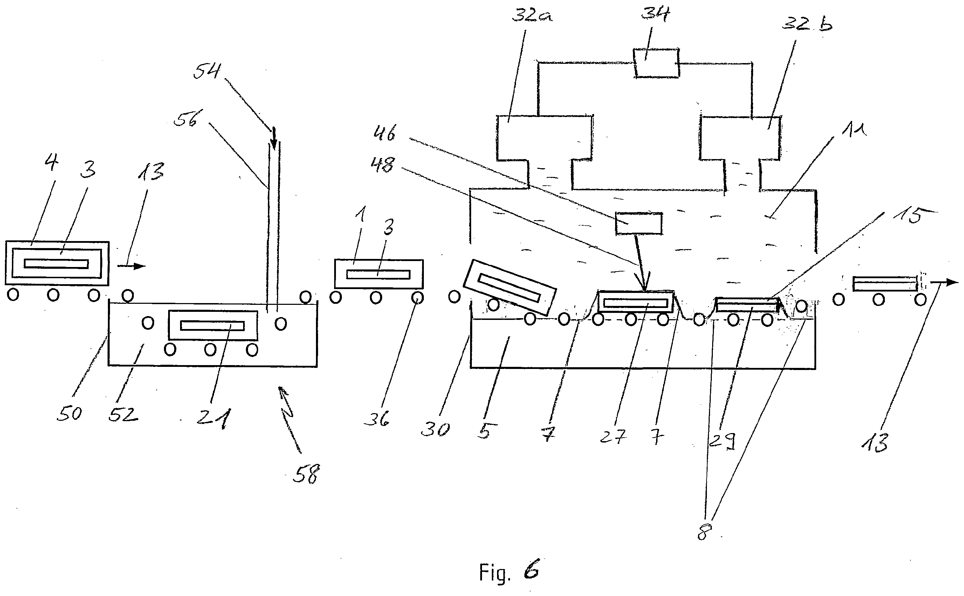

Figur 6 zeigt ein weiteres Ausführungsbeispiel einer Vorrichtung zum wenigstens teilweisen Rückätzen einer Halbleiterschicht in einer schematischen Darstellung. Sie weist zusätzlich zu den bereits aus Figur 4 bekannten Vorrichtungsbestandteilen eine Vorätzeinrichtung 58 auf, mittels welcher die Halbleiterschicht und/oder eine auf der Halbleiterschicht 1 angeordnete Silikatglasschicht 4 vor der Rückätzung der Halbleiterschicht 1 mittels der reaktiven Dämpfe 11 zumindest teilweise abgetragen werden kann. In der vorliegenden Ausgestaltungsvariante weist die Vorätzeinrichtung 58 einen Behälter 50 auf, in welchem eine Zusatzätzlösung 52 angeordnet ist. Weiterhin ist eine Gaszufuhr 56 vorgesehen, mittels welcher im vorliegenden Fall Ozon 54 in die Zusatzätzlösung eingeleitet werden kann. Die Einleitung anderer reaktiver Gase ist ebenfalls möglich. Als Zusatzätzlösung kann beispielsweise eine flusssäurehaltige Lösung verwendet werden.

Bei dem in Figur 6 illustrierten Ausführungsbeispiel eines Verfahrens zum wenigstens teilweisen Rückätzen einer Halbleiterschicht wird zunächst eine auf der dotierten Halbleiterschicht 1 angeordnete Silikatglasschicht 4 mittels der Zusatzätzlösung 52 entfernt. Die Rückätzrate der Zusatzätzlösung kann dabei unter anderem über Ozon 54 eingestellt werden, welches über die Gaszufuhr 56 in die Zusatzätzlösung 52 eingeleitet wird. Das nach Entfernung der Silikatglasschicht verbleibende Solarzellensubstrat 21 wird im Weiteren dem Behälter 30 und der darin angeordneten Ätzlösung 5 zugeführt.

Optional kann mittels der Vorätzeinrichtung 58, wie oben angedeutet, auch bereits vorab ein Teil der dotierten Halbleiterschicht 1 mittels der Zusatzätzlösung 52 rückgeätzt werden. Wie bereits weiter oben dargelegt, ermöglicht dies in Verbindung mit dem nachfolgenden Rückätzen der dotierten Halbleiterschicht 1 mittels der reaktiven Dämpfe 11 eine hohe Rückätzrate für die dotierte Halbleiterschicht 1 bei gleichzeitig guter Einstellbarkeit.

Die Vorätzeinrichtung 58 kann in einer anderen Ausgestaltungsvariante auch in Transportrichtung 13 nach der Ätzlösung 5 angeordnet und somit als Nachätzeinrichtung eingesetzt werden.

Die Vorätzeinrichtung 58 kann ohne weiteres auch mit den Vorrichtungen bzw. Verfahren aus den Figuren 1 bis 4 in analoger Weise wie in Figur 6 dargestellt kombiniert werden. In gleicher Weise wie im Zusammenhang mit Figur 6 beschrieben ist zudem der Einsatz als Nachätzeinrichtung möglich. Ferner ist es denkbar, wenigstens eine der aus den Figuren 3 und 4 bekannten Beleuchtungsvorrichtungen in dem Ausführungsbeispiel der Figur 2 vorzusehen.

In sämtlichen Ausführungsbeispielen wurde davon ausgegangen, dass die dotierte Halbleiterschicht 1 die Oberfläche des Solarzellensubstrats vollständig bedeckt. Dies ist jedoch nicht zwingend erforderlich. Beispielsweise können sämtliche Ausführungsbeispiele von Vorrichtungen und Verfahren auch auf Substrate angewandt werden, welche nur teilweise mit einer Halbleiterschicht versehen sind. Beispielsweise kann die dotierte Halbleiterschicht von vorneherein nur auf der Emitterseite eines Solarzellensubstrats angeordnet sein. In diesem Fall entfällt offensichtlich die Entfernung der dotierten Halbleiterschicht in Bereichen die sich in der Ätzlösung 5 befinden und damit die Kantenisolation. Die auf der Emitterseite aufgebrachte dotierte Halbleiterschicht kann dennoch mit den Vorrichtungen und Verfahren der Figuren 1 bis 4 und 6 rückgeätzt, insbesondere lokal rückgeätzt werden.

### Bezugszeichenliste

- 1: dotierte Halbleiterschicht
- 3: Solarzellensubstrat
- 4: Silikatglasschicht
- 5: Ätzlösung
- 7: Oberfläche der Ätzlösung
- 8: Flüssigkeitsspiegel der Ätzlösung
- 9: Emitterseite des Solarzellensubstrats
- 11: reaktive Dämpfe
- 13: Transportrichtung Substrat
- 15: rückgeätzter Emitter
- 17: Solarzellensubstrat mit teilweise abgetragener dotierter Halbleiterschicht
- 19: Solarzellensubstrat mit isolierten Kanten
- 21: nach Entfernung Silikatglasschicht verbleibendes Solarzellensubstrat
- 26: lokal stärker rückgeätzter Emitter
- 27: lokal bestrahltes Solarzellensubstrat
- 29: Solarzellensubstrat mit isolierten Kanten und lokal stärker rückgeätztem Emitter
- 30: Behälter
- 32a: Absaugeinrichtung
- 32b: Absaugeinrichtung
- 33a: Absaugöffnung
- 33b: Absaugöffnung
- 34: Regeleinrichtung
- 36: Transportrolle
- 37: Gasverteilerplatte
- 38: Inertgas
- 39: Öffnung
- 40: Gaszuführung
- 42: UV-Lampe
- 44: Bestrahlungsmaske
- 46: Laser und Lasersteuereinrichtung
- 48: Laserstrahl
- 50: Behälter
- 52: Zusatzätzlösung
- 54: Ozon
- 56: Gaszufuhr
- 58: Vorätzeinrichtung
- 60: Substrat
- 62: Oberseite des Substrats

## Patentansprüche

1. Verfahren zum wenigstens teilweisen Rückätzen einer Halbleiterschicht (1) eines Substrats (3), bei welchem das Substrat (3) zumindest teilweise außerhalb einer Ätzlösung (5) angeordnet wird,
**dadurch gekeinnzeichnet,** dass
- außerhalb der Ätzlösung (5) gelegene Bereiche der Halbleiterschicht (3) mittels der Ätzlösung (5) entstammender reaktiver Dämpfe (11) wenigstens zum Teil abgetragen werden und
- zur Einstellung der Rückätzrate der reaktiven Dämpfe (11) ein Inertgas (38) und/oder wenigstens ein Reaktivgas den außerhalb der Ätzlösung (5) gelegenen Bereichen der rückzuätzenden Halbleiterschicht (1) zugeführt wird.

2. Verfahren nach Anspruch 1,
dadurch gekeinnzeichnet,
dass das Substrat (3) derart angeordnet wird, dass Teile der Halbleiterschicht (1) sich in der Ätzlösung (5) befinden, und dass diese Teile der Halbleiterschicht (1) mittels der Ätzlösung (5) vollständig entfernt werden.

3. Verfahren nach Anspruch 2,
**dadurch gekennzeichnet,**
**dass** außerhalb der Ätzlösung (5) befindliche Teile der Halbleiterschicht (1) mittels der reaktiven Dämpfe (11) nur bis zu einer verbleibenden Restdicke der Halbleiterschicht (1) abgetragen werden.

4. Verfahren nach einem der vorangehenden Ansprüche,
**dadurch gekennzeichnet,**
**dass** ein Emitter (15) eines Solarzellensubstrats (11) rückgeätzt wird.

5. Verfahren nach Anspruch 4,
**dadurch gekennzeichnet,**
**dass** das Solarzellensubstrat (3) derart angeordnet wird, dass sich eine spätere Emitterseite (9) des Solarzellensubstrats (3) außerhalb der Ätzlösung (5) befindet und sich eine der Emitterseite (9) gegenüberliegende Seite des Solarzellensubstrats (3) in der Ätzlösung (5) befindet.

6. Verfahren nach einem der vorangegangene Ansprüche,
**dadurch gekennzeichnet,**
**dass** eine auf der rückzuätzenden Halbleiterschicht (1) vorhandene Silikatglasschicht (4) vor dem Rückätzen der Halbleiterschicht (1) entfernt wird, vorzugsweise nasschemisch.

7. Verfahren nach einem der vorangegangenen Ansprüchen,
**dadurch gekennzeichnet,**
**dass** zur Einstellung einer Rückätzrate für das Rückätzen der Halbleiterschicht (1) die reaktiven Dämpfe (11) teilweise abgesaugt werden.

8. Verfahren nach einem der vorangegangenen Ansprüchen,
**dadurch gekennzeichnet,**
**dass** als wenigstens ein Reaktivgas mindestens ein Element aus der Gruppe bestehend aus gasförmigem Ozon und gasförmigem Fluorwasserstoff verwendet wird.

9. Verfahren nach einem der vorangegangenen Ansprüchen,
**dadurch gekennzeichnet,**
**dass** zur Einstellung einer Rückätzrate für das Rückatzen der Halbleiterschicht (1) außerhalb der Ätzlösung (5) gelegene Bereiche der rückzuätzenden Halbleiterschicht (1) während des Rückätzens mit elektromagnetischer Strahlung (42; 48) bestrahlt werden, vorzugsweise mit UV-Licht (42).

10. Verfahren nach einem der vorangegangenen Ansprüche,
**dadurch gekennzeichnet,**
**dass**, bevor oder nachdem in einem Hauptätzschritt nach einein der vorangehenden Ansprüche wenigstens ein Teil der Halbleiterschicht (1) abgetragen wird, das Substrat (3) in einem zusätzlichen Ätzschritt zumindest teilweise, vorzugsweise vollständig, in einem Zusatzätzmedium (52) angeordnet wird, mittels welchem die Halbleiterschicht (1) teilweise rückgeätzt wird.

11. Verfahren nach den Ansprüchen 10 und 6,
**dadurch gekennzeichnet,**
**dass** die Silikatglasschicht (4) in dem zusätzlichen Ätzschritt mittels des Zusatzätzmediums (52) entfernt wird, bevor der Hauptätzschritt durchgeführt wird.

12. Vorrichtung zur Durchführung des Verfahrens nach einem der Ansprüche 1 bis 11
- aufweisend einen Behälter (30) für eine Ätzlösung (5),
- wobei ein Substrat (3) relativ zu der Ätzlösung (5) derart anordenbar ist, dass dieses zumindest teilweise außerhalb der in dem Behälter (30) angeordneten Ätzlösung (5) liegt,
- weiterhin aufweisend eine Absaugeinrichtung (32a, 32b; 33a, 33b) zur Absaugung von der Ätzlösung (5) entstammenden, reaktiven Dämpfen (11) und
- weiterhin aufweisend wenigstens eine Gaszuführung (40), mittels welcher außerhalb der Ätzlösung (5) gelegenen Bereichen der Halbleiterschicht Gase (38) zuführbar sind,
**dadurch gekennzeichnet, dass**
- mittels der Absaugeinrichtung (32a, 32b; 33a, 33b) die reaktiven Dämpfe (11) derart absaugbar sind, dass außerhalb der Ätzlösung (5) gelegene Bereiche einer Halbleiterschicht (1) des Substrats (3) mittels der reaktiven Dämpfe (11) homogen rückätzbar sind, und
- eine Vorätzeinrichtung (58) vorgesehen ist, welche dazu geeignet ist, die Halbleiterschicht (1) und/oder eine auf der Halbleiterschicht (1) angeordnete Silikatglasschicht (4) vor der Rückätzung der Halbleiterschicht (1) mittels der reaktiven Dämpfe (11) zumindest teilweise abzutragen, und welche in einer Transportrichtung (13) des Substrats (3) vor dem Behälter (30) für die Ätzlösung (5) angeordnet ist.

13. Vorrichtung nach Anspruch 12,
**gekennzeichnet durch**
wenigstens eine Bestrahlungsvorrichtung (42; 46), vorzugsweise eine UV-Lichtquelle (42), mittels welcher die Substrate (3), vorzugsweise die außerhalb der Ätzlösung (5) gelegenen Bereiche der Halbleiterschicht (1), mit elektromagnetischer Strahlung (42; 48) bestrahlbar sind, wobei die wenigstens eine Bestrahlungsvorrichtung (42; 46) bevorzugt derart eingerichtet ist, dass die Substrate (3) lokal bestrahlbar sind.

14. Vorrichtung nach Anspruch 13,
**gekennzeichnet durch**
eine zwischen der wenigstens einen Bestrahlungsvorrichtung (42) und der Ätzlösung (5) angeordnete Bestrahlungsmaske (44), mittels welcher die Substrate (3), vorzugsweise die außerhalb der Ätzlösung (5) gelegenen Bereiche der Halbleiterschicht (1), lokal bestrahlbar sind.

## Claims

1. Method for the at least partial etch back of a semiconductor layer (1) of a substrate (3) for which the substrate (3) is placed at least partially outside an etching solution (5),
**characterized in that**
- areas of the semiconductor layer (3) situated outside the etching solution (5) are at least partially removed by means of reactive vapors (11) originating from the etching solution (5) and
- for adjusting the etch back rate of the reactive vapors (11) an inert gas (38) and/or at least one reactive gas is supplied to the areas of the semiconductor layer to be etched back (1) that are situated outside the etching solution (5).

2. Method according to claim 1, **characterized in that** the substrate (3) is placed in such a manner that parts of the semiconductor layer (1) are situated in the etching solution (5) and that these parts of the semiconductor layer (1) are completely removed by means of the etching solution (5).

3. Method according to claim 2, **characterized in that** parts of the semiconductor layer (1) that are situated outside the etching solution (5) are removed by means of the reactive vapors (11) only up to a remaining residual thickness of the semiconductor layer (1).

4. Method according to one of the preceding claims, **characterized in that** an emitter (15) of a solar cell substrate (11) is etched back.

5. Method according to claim 4, **characterized in that** the solar cell substrate (3) is placed in such a manner that a later emitter side (9) of the solar cell substrate (3) is situated outside the etching solution (5) and that a side of the solar cell substrate (3) opposite to the emitter side (9) is situated in the etching solution (5).

6. Method according to one of the preceding claims, **characterized in that** a silicate glass layer (4) existing on the semiconductor layer to be etched back (1) is removed before etching back the semiconductor layer (1), preferably by a wet chemical technique.

7. Method according to one of the preceding claims, **characterized in that** the reactive vapors (11) are partially sucked off for adjusting an etch back rate for the etch back of the semiconductor layer (1).

8. Method according to one of the preceding claims, **characterized in that** an element from the group consisting of gaseous ozone and gaseous hydrogen fluoride is used as at least one reactive gas.

9. Method according to one of the preceding claims, **characterized in that** areas of the semiconductor layer to be etched back (1) situated outside the etching solution (5) are irradiated during the etch back with electromagnetic radiation (42; 48), preferably with UV-light (42), for adjusting an etch back rate for the etch back of the semiconductor layer (1).

10. Method according to one of the preceding claims, **characterized in that**, before or after at least one part of the semiconductor layer (1) is removed in a main etching step according to one of the preceding claims, the substrate (3) is placed in an additional etching step at least partially, preferably completely, in an additional etching medium (52) by means of which the semiconductor layer (1) is partially etched back.

11. Method according to the claims 10 and 6, **characterized in that** the silicate glass layer (4) is removed in the additional etching step by means of the additional etching medium (52) before the main etching step is carried out.

12. Device for carrying out the method according to one of the claims 1 to 11
- that has a container (30) for an etching solution (5),
- wherein a substrate (3) can be placed relative to the etching solution (5) in such a manner that it is situated at least partially outside the etching solution (5) placed in the container (30),
- that furthermore has a suction device (32a, 32b; 33a, 33b) for sucking the reactive vapors (11) originating from the etching solution (5) and
- that furthermore has at least one gas supply (40) by means of which gases (38) can be supplied to areas of the semiconductor layer that are situated outside the etching solution (5),
**characterized in that**
- the reactive vapors (11) can be sucked off by means of the suction device (32a, 32b; 33a, 33b) in such a manner that areas of a semiconductor layer (1) of the substrate (3) that are situated outside the etching solution (5) can be homogeneously etched back by means of the reactive vapors (11) and
- a pre-etching device (58) is provided that is appropriate to at least partially remove the semiconductor layer (1) and/or a silicate glass layer (4) placed on the semiconductor layer (1) before the etch back of the semiconductor layer (1) by means of the reactive vapors (11) and that is placed in a transport direction (13) of the substrate (3) before the container (30) for the etching solution (5).

13. Device according to claim 12, **characterized by** at least one irradiation device (42; 46), preferably a UV light source (42) by means of which the substrates (3), preferably the areas of the semiconductor layer (1) situated outside the etching solution (5) can be irradiated with electromagnetic radiation (42; 48), wherein the at least one irradiation device (42; 46) is preferably configured in such a manner that the substrates (3) can be locally irradiated.

14. Device according to claim 13, **characterized by** an irradiation mask (44) placed between the at least one irradiation device (42) and the etching solution (5) by means of which the substrates (3), preferably the areas of the semiconductor layer (1) situated outside the etching solution (5), can be locally irradiated.

## Revendications

1. Procédé pour le décapage au moins partiel d'une couche semiconductrice (1) d'un substrat (3) pour lequel le substrat (3) est placé au moins partiellement à l'extérieur d'une solution de gravure (5),
**caractérisé en ce que**
- des zones de la couche semiconductrice (3) situées à l'extérieur de la solution de gravure (5) sont enlevées au moins en partie au moyen de vapeurs réactives (11) émanant de la solution de gravure (5) et
- qu'un gaz inerte (38) et/ou au moins un gaz réactif est amené aux zones de la couche semiconductrice devant être décapée (1) situées à l'extérieur de la solution de gravure (5) pour l'ajustement du taux de décapage des vapeurs réactives (11).

2. Procédé selon la revendication 1, **caractérisé en ce que** le substrat (3) est placé de telle manière que des parties de la couche semiconductrice (1) se trouvent dans la solution de gravure (5) et que ces parties de la couche semiconductrice (1) sont complètement enlevées au moyen de la solution de gravure (5).

3. Procédé selon la revendication 2, **caractérisé en ce que** des parties de la couche semiconductrice (1) qui se trouvent à l'extérieur de la solution de gravure (5) ne sont enlevées au moyen des vapeurs réactives (11) que jusqu'à une épaisseur résiduelle restante de la couche semiconductrice (1).

4. Procédé selon l'une des revendications précédentes, **caractérisé en ce qu'**un émetteur (15) d'un substrat de cellule solaire (11) est décapé.

5. Procédé selon la revendication 4, **caractérisé en ce que** le substrat de cellule solaire (3) est placé de telle manière qu'un côté émetteur ultérieur (9) du substrat de cellule solaire (3) se trouve à l'extérieur de la solution de gravure (5) et qu'un côté du substrat de cellule solaire (3) opposé au côté émetteur (9) se trouve dans la solution de gravure (5).

6. Procédé selon l'une des revendications précédentes, **caractérisé en ce qu'**une couche de verre de silicate (4) existant sur la couche semiconductrice à décaper (1) est enlevée avant le décapage de la couche semiconductrice (1), de préférence par voie chimique humide.

7. Procédé selon l'une des revendications précédentes, **caractérisé en ce que** les vapeurs réactives (11) sont partiellement aspirées pour l'ajustement d'un taux de décapage pour le décapage de la couche semiconductrice (1).

8. Procédé selon l'une des revendications précédentes, **caractérisé en ce qu'**un élément du groupe constitué par l'ozone gazeux et par le fluore d'hydrogène gazeux est utilisé comme au moins un gaz réactif.

9. Procédé selon l'une des revendications précédentes, **caractérisé en ce que** des zones de la couche semiconductrice à décaper (1) situées à l'extérieur de la solution de gravure (5) sont irradiées pendant le décapage avec un rayonnement électromagnétique (42 ; 48), de préférence avec de la lumière UV (42), pour l'ajustement d'un taux de décapage pour le décapage de la couche semiconductrice (1).

10. Procédé selon l'une des revendications précédentes, **caractérisé en ce que** avant ou après qu'au moins une partie de la couche semiconductrice (1) est enlevée dans une étape de gravure principale selon l'une des revendications précédentes, le substrat (3) est placé dans une étape de gravure supplémentaire au moins partiellement, de préférence entièrement, dans un agent de gravure supplémentaire (52) au moyen duquel la couche semiconductrice (1) est partiellement décapée.

11. Procédé selon les revendications 10 et 6, **caractérisé en ce que** la couche de verre de silicate (4) est enlevé dans l'étape de gravure supplémentaire au moyen de l'agent de gravure supplémentaire (52) avant que l'étape de gravure principale soit exécutée.

12. Dispositif pour exécuter le procédé selon l'une des revendications 1 à 11
- qui présente un réservoir (30) pour une solution de gravure (5),
- cependant qu'un substrat (3) peut être placé par rapport à la solution de gravure (5) de telle manière que celui-ci se situe au moins partiellement à l'extérieur de la solution de gravure (5) placée dans le réservoir (30),
- qui présente de plus un dispositif d'aspiration (32a, 32b ; 33a, 33b) pour l'aspiration de vapeurs réactives (11) émanant de la solution de gravure (5) et
- qui présente de plus au moins une conduite d'amenée de gaz (40) au moyen de laquelle des gaz (38) peuvent être amenés à des zones de la couche semiconductrice situées à l'extérieur de la solution de gravure (5), **caractérisé en ce que**
- les vapeurs réactives (11) peuvent être aspirées au moyen du dispositif d'aspiration (32a, 32b ; 33a, 33b) de telle manière que des zones d'une couche semiconductrice (1) du substrat (3) situées à l'extérieur de la solution de gravure (5) peuvent être décapées de manière homogène au moyen des vapeurs réactives (11) et
- qu'il est prévu un dispositif de pré-gravure (58) qui est approprié pour enlever au moins partiellement la couche semiconductrice (1) et/ou une couche de verre de silicate (4) placée sur la couche semiconductrice (1) avant le décapage de la couche semiconductrice (1) au moyen des vapeurs réactives (11) et qui est placé dans un sens de transport (13) du substrat (3) devant le réservoir (30) pour la solution de gravure (5).

13. Dispositif selon la revendication 12, **caractérisé par** au moins un dispositif d'irradiation (42 ; 46), de préférence une source de lumière UV (42), au moyen duquel les substrats (3), de préférence les zones de la couche semiconductrice (1) situées à l'extérieur de la solution de gravure (5), peuvent être irradiés avec un rayonnement électromagnétique (42 ; 48), cependant que le dispositif d'irradiation qui existe au moins (42 ; 46) est agencé de manière préférée de telle manière que les substrats (3) soient irradiés localement.

14. Dispositif selon la revendication 13, **caractérisé par** un masque d'irradiation (44) placé entre le dispositif d'irradiation qui existe au moins (42) et la solution de gravure (5), masque au moyen duquel les substrats (3), de préférence les zones de la couche semiconductrice (1) situées à l'extérieur de la solution de gravure (5), peuvent être irradiés localement.
